# EUROPÄISCHE PATENTSCHRIFT

(11) **EP 1 215 950 B1**
(45) Veröffentlichungstag und Bekanntmachung des Hinweises auf die Patenterteilung: **25.02.2009**
(21) Anmeldenummer: 00127331.7
(22) Anmeldetag: 13.12.2000
(51) Int. Cl.: H05K 5/06

(54) **Stellantrieb mit einem Gehäuse mit Abdichtung**
Actuator casing with seal
Boîtier d'actionneur avec joint d'étanchéité

(43) Veröffentlichungstag der Anmeldung: 19.06.2002
(73) Patentinhaber: SIEMENS AKTIENGESELLSCHAFT, 80333 München (DE)
(72) Erfinder: Grossenbacher, Christian, 5622 Waltenschwil (CH)

(56) Entgegenhaltungen:
- EP-A- 0 777 407
- EP-A- 0 798 564
- DE-A- 3 927 528
- FR-A- 2 762 660
- GB-A- 975 059

## Beschreibung

Die Erfindung bezieht sich auf einen Stellantrieb der im Oberbegriff des Anspruchs 1 genannten Art.

Solche Stellantriebe werden vorteilhaft in der Heizungs-, Lüftungs- und Klimatechnik zur Betätigung von Stellgliedern - wie Lüftungsklappen, Ventile und dergleichen - verwendet.

Ein Gehäuse für einen derartigen Stellantrieb muss elektromechanische und elektronische Komponenten des Stellantriebs vor Verschmutzung und Spritzwasser schützen und in dieser Hinsicht auch gewisse Normen erfüllen.

Ein Stellantrieb der im Oberbegriff des Anspruchs 1 genannten Art ist beispielsweise aus dem Datenblatt CM2N4613D der Firma Siemens Building Technologies bekannt.

Weitere Gehäuse, durch welche elektromechanische oder elektronische Komponenten oder Baugruppen vor Verschmutzung oder Spritzwasser schützbar sind, wurden beispielsweise in DE 39 27 528 A, GB 975 059 A oder EP 777 407 A vorgeschlagen.

Die bekannten Gehäuse haben jedoch den Nachteil, dass sie zur Erreichung der erforderlichen Dichtheit zusätzliche Dichtungselemente wie Dichtungsringe, -schnüre oder -bänder aufweisen, die in entsprechenden Nuten der Gehäuse eingesetzt sind. Es ist ferner bekannt, Fugen eines Gehäuses mit verschiedenartigen Pasten abzudichten. Bekannte Mittel zum Abdichten bringen jedoch mindestens einen der nachfolgend aufgezählten Nachteile mit sich:
- Das Dichtungselement altert und muss ersetzt werden.
- Das Dichtungselement muss genau an die Form des Gehäuseteils angepasst und sorgfältig platziert werden.
- Das Dichtungselement muss nach dem Öffnen des Gehäuses ersetzt werden.
- Das Gehäuse wird durch das Dichtungselement gasdicht abgeschlossen, so dass sich im Innenraum des Gehäuses Kondenswasser bilden kann, was die erforderliche Sicherheit und Zuverlässigkeit des Stellantriebs nicht mehr garantiert.

Ein weiteres Beispiel ist aus dem Dokument EP 0 798 564 A bekannt.

Der Erfindung liegt die Aufgabe zugrunde, für einen Stellantrieb ein Gehäuse mit Abdichtung vorzuschlagen, bei dem die oben aufgezählten Nachteile nicht auftreten.

Die genannte Aufgabe wird erfindungsgemäss durch die Merkmale des Anspruchs 1 gelöst. Vorteilhafte Ausgestaltungen ergeben sich aus den abhängigen Ansprüchen.

Nachfolgend werden Ausführungsbeispiele der Erfindung anhand der Zeichnung näher erläutert.

Es zeigen:
- Fig. 1: ein Stellantrieb mit einem Gehäuse mit Abdichtung,
- Fig. 2: ein erstes Gehäuseteil mit einem Rand,
- Fig. 3: eine Schnittdarstellung B-B des Randes des in der Fig. 2 dargestellten ersten Gehäuseteils,
- Fig. 4: ein zweites Gehäuseteil mit einem Rand,
- Fig. 5: eine Schnittdarstellung A-A des Randes des in der Fig. 4 dargestellten zweiten Gehäuseteils, und
- Fig. 6: eine Schnittdarstellung eines Details der beiden zusammengefügten Gehäuseteile.

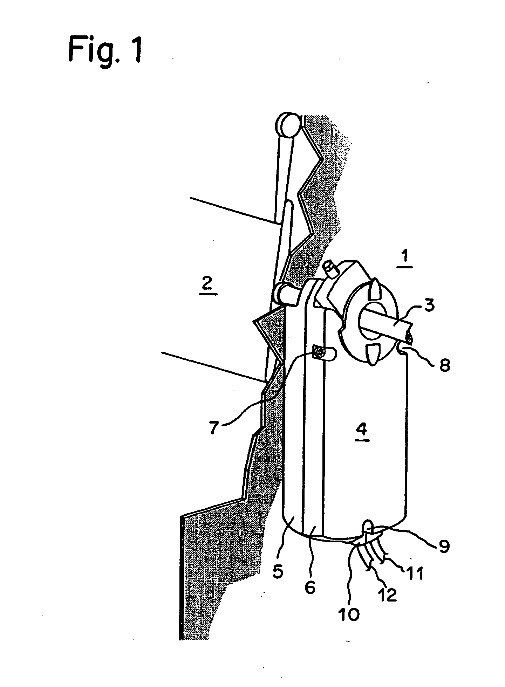

In der Fig. 1 bedeutet 1 einen Stellantrieb zum Betätigen eines Stellgliedes 2. Das Stellglied 2 - im Beispiel eine Lüftungsklappe - ist über eine drehbare Achse 3 betätigbar. Der Stellantrieb 1 weist ein Gehäuse 4 mit einem ersten Gehäuseteil 5 und einem zweiten Gehäuseteil 6 auf. Die beiden Gehäuseteile 5 und 6 sind mit Vorteil durch Schrauben 7, 8 und 9 miteinander lösbar verbunden. Der Stellantrieb 1 weist eine Zuführung 10 für Anschlüsse 11 und 12 auf. Die Anschlüsse 11 und 12 dienen der Kommunikation und/oder der Speisung. Typischerweise sind die Anschlüsse 11 und 12 für ein elektrisches Stellsignal. Bei Bedarf weist die Zuführung 10 weitere Anschlüsse - beispielsweise zur Positionsrückmeldung oder zur Energieversorgung - auf.

Die Geometrie und die Funktionalität des Gehäuses 4 sind vorteilhafterweise einerseits auf zu schützende elektronische, elektrische und mechanische Bauelementen und - gruppen des Stellantriebs 1 und andrerseits auf die Anordnung des Stellantriebs 1 am Stellglied 2 ausgerichtet, wobei jeweils insbesondere eine kostengünstige aber sichere und funktionsgerechte Montage im Vordergrund steht.

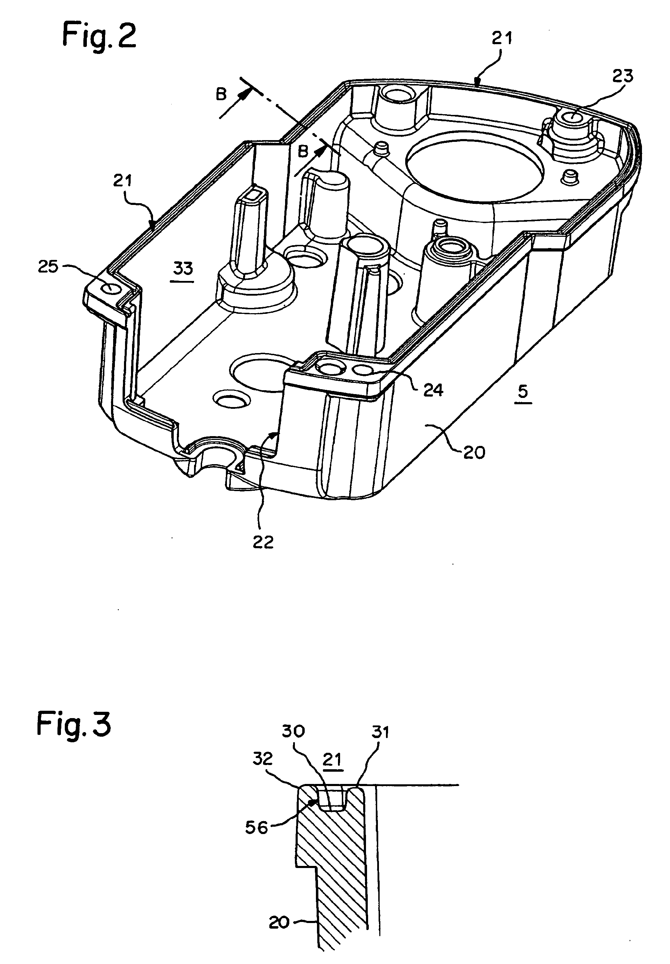

In der Fig. 2 ist beispielhaft eine prinzipiell als Schale ausgebildete Ausführung des ersten Gehäuseteils 5 dargestellt. Das erste Gehäuseteil 5 weist einen hochgezogenen Rand 20 mit einer Stirnfläche 21 auf, durch die das erste Gehäuseteil 5 im wesentlichen begrenzt ist. Mit Vorteil weist der hochgezogene Rand 20 eine Ausnehmung 22 für die Zuführung 10 (Fig. 1) auf.

Das erste Gehäuseteil 5 weist mit Vorteil Löcher 23, 24, 25 für die Schrauben 7, 8 und 9 (Fig. 1) auf.

In einer vorteilhaften Ausführung des ersten Gehäuseteils 5 weist der Rand 20 im Bereich der Stirnfläche 21 eine Nut 30 zwischen Rippen 31 und 32 auf (Fig. 3), wobei eine erste Rippe 31 an einen Gehäuseinnenraum 33 (Fig. 2) grenzt und eine zweite Rippe 32 am Gehäuse 4 (Fig. 1) gegen aussen liegt.

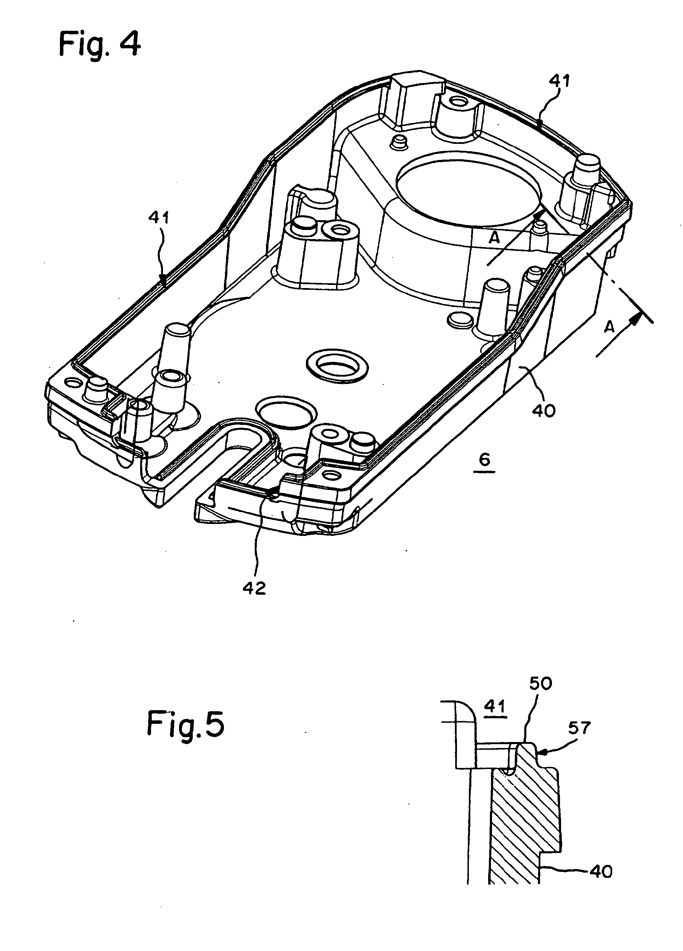

In der Fig. 4 ist beispielhaft eine prinzipiell als Deckel ausgebildete Ausführung des zweiten Gehäuseteils 6 dargestellt. Das zweite Gehäuseteil 6 weist einen hochgezogenen Rand 40 mit einer Stirnfläche 41 auf, durch die das zweite Gehäuseteil 6 im wesentlichen begrenzt ist. Mit Vorteil weist auch der hochgezogene Rand 40 eine Ausnehmung 42 für die Zuführung 10 (Fig. 1) auf.

Das zweite Gehäuseteil 6 weist mit Vorteil Löcher 43, 44, 45 für die Schrauben 7, 8 und 9 (Fig. 1) auf.

In einer vorteilhaften Ausführung des zweiten Gehäuseteils 6 weist der Rand 40 im Bereich der Stirnfläche 41 einen als Gegenstück zur Nut 30 (Fig. 3) ausgebildeten Wulst 50 auf (Fig. 5).

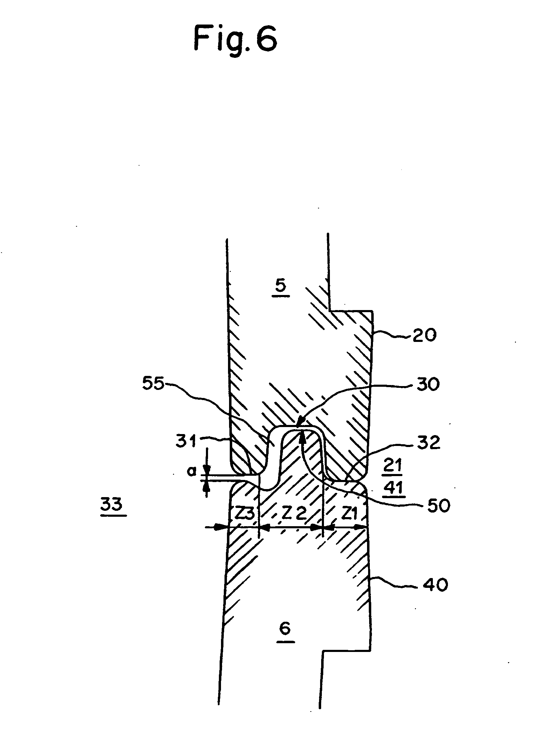

Das Gehäuse 4 weist eine erfindungsgemässe Abdichtung auf, wenn die beiden Gehäuseteile 5 und 6 derart zusammengefügt werden, dass die beiden Stirnflächen 21 und 41 sich gegenüberliegen (Fig. 6), wobei das erste Gehäuseteil 5 und das zweite Gehäuseteil lösbar und direkt - also ohne zusätzliches Dichtungselement - aufeinander gelegt werden. Die beiden Stirnflächen 21 und 41 sind derart ausgestaltet, dass sich beim Zusammenfügen der beiden Gehäuseteile 5 und 6 zwischen den beiden Stirnflächen 21 und 41 im wesentlichen drei verschieden wirkende Zonen ausbilden. Am Gehäuse 4 gegen aussen liegend bildet sich eine erste Zone Z1 aus, in der sich die beiden Gehäuseteile 5 und 6 berühren. Neben der ersten Zone Z1, gegen innen bildet sich eine zweite, einen Kanal 55 aufweisende Zone Z2 aus. Der Kanal 55 der zweiten Zone Z2 wird gegen den Gehäuseinnenraum 33 hin durch eine dritte Zone Z3 abgeschlossen, in der sich die beiden Gehäuseteile 5 und 6 nicht berühren, wobei der Abstand a zwischen den beiden Gehäuseteilen 5 und 6 in der dritten Zone Z3 derart bemessen ist, dass allfällig im Kanal 55 der zweiten Zone Z2 vorhandenes Wasser wegen Oberflächenspannungen nicht über die dritte Zone Z3 hinaus in den Gehäuseinnenraum 33 abfliessen kann.

Obwohl sich die beiden Gehäuseteile 5 und 6 in der ersten Zone Z1 berühren, ist das Gehäuse 4 in der Zone Z1 nicht gasdicht verschlossen. Dies bringt den Vorteil, dass allfällig vorhandene Gase und insbesondere Wasserdampf aus dem Gehäuseinnenraum 33 entweichen könnten, so dass die Gefahr eines Niederschlags von Kondenswasser im Gehäuseinnenraum 33 reduziert wird und das Gehäuse trotzdem einen wirksamen Schutz gegen Spritzwasser und Verschmutzung bietet.

Damit eine gute Passform zwischen den beiden Gehäuseteilen 5 und 6 erreicht und ein gegenseitiges Verschieben entlang des Randes 20 oder 40 verhindert wird, sind die Formen der beiden Stirnflächen 21 und 41 so aufeinander abzustimmen, dass ein gegenseitiger Anschlag mit Vorteil im Übergangsbereich zwischen der ersten Zone Z1 und der zweiten Zone Z2 ausgeformt ist.

Mit Vorteil ist eine gegenseitige Positionierung der beiden Gehäuseteile 5 und 6 insbesondere durch eine an die erste Zone Z1 angrenzende Seitenwand 56 (Fig. 3) der Nut 30 und eine weitere an die erste Zone Z1 angrenzende Seitenwand 57 (Fig. 5) des Wulstes 50 bestimmt.

Die beiden Gehäuseteile 5 und 6 werden mit Vorteil durch mehrere Schrauben 7, 8 und 9 miteinander verbunden.

Das Gehäuse 4 wird mit Vorteil durch Giessen einer Leichtmetalllegierung hergestellt, beispielhaft durch Druckgiessen einer Aluminiumlegierung.

Damit bei Leichtmetalldruckguss allfällig im Kanal 55 der zweiten Zone Z2 vorhandenes Wasser nicht über die dritte Zone Z3 hinaus in den Gehäuseinnenraum 33 abfliessen kann, sind die beiden Ränder 20 und 40 an den Stirnflächen 21 beziehungsweise 41 derart aufeinander abzustimmen, dass der minimale Abstand a zwischen den beiden Gehäuseteilen 5 und 6 in der dritten Zone Z3 zwischen 0,1 mm und 0,2 mm beträgt. Bei Aluminiumdruckguss beträgt der minimale Abstand a mit Vorteil 0,15 mm

## Patentansprüche

1. Stellantrieb (1) mit einem Gehäuse (4), welches ein erstes Gehäuseteil (5) und ein zweites Gehäuseteil (6) aufweist, wobei die beiden Gehäuseteile (5; 6) je einen Rand (20; 40) mit je einer Stirnfläche (21; 41) aufweisen und wobei beim Zusammenfügen der beiden Gehäuseteile (5; 6) die beiden Stirnflächen (21; 41) sich gegenüberliegen,
wobei,
das erste Gehäuseteil (5) und das zweite Gehäuseteil (6) lösbar und direkt zusammenfügbar sind,
dass sich beim Zusammenfügen der beiden Gehäuseteile (5; 6) zwischen den beiden Stirnflächen (21; 41) verschieden wirkende Zonen ausbilden,
wobei am Gehäuse (4) gegen aussen liegend sich eine erste Zone (Z1) ausbildet, in der sich die beiden Gehäuseteile (5; 6) berühren, und
neben der ersten Zone (Z1) gegen innen sich eine zweite, einen Kanal (55) aufweisende Zone (Z2) ausbildet, und **dadurch gekennzeichnet, dass**
der Kanal (55) der zweiten Zone (Z2) im Gehäuse (4) gegen einen Gehäuseinnenraum (33) hin durch eine dritte Zone (Z3) abgeschlossen wird, in der sich die beiden Gehäuseteile (5; 6) nicht berühren, wobei der Abstand (a) zwischen den beiden Gehäuseteilen (5; 6) in der dritten Zone (Z3) derart bemessen ist, dass allfällig in der zweiten Zone (Z2) vorhandenes Wasser wegen Oberflächenspannungen nicht über die dritte Zone hinaus in den Gehäuseinnenraum (33) abfliessen kann.

2. Stellantrieb nach Anspruch 1, **dadurch gekennzeichnet, dass** die Formen der beiden Stirnflächen (21; 41) so aufeinander abgestimmt sind, dass ein gegenseitiger Anschlag im Übergangsbereich zwischen der ersten Zone (Z1) und der zweiten Zone (Z2) ausgeformt ist, durch den ein gegenseitiges Verschieben der beiden Gehäuseteile (5; 6) entlang des Randes (20; 40) verhinderbar ist.

3. Stellantrieb nach einem vorangehenden Anspruch, **dadurch gekennzeichnet, dass** in der Stirnfläche (21) des ersten Gehäuseteils (5) im Bereich der zweiten Zone (Z2) eine Nut (30) und in der Stirnfläche (41) des zweiten Gehäuseteils (6) als Gegenstück zur Nut (30) ein Wulst (50) ausgebildet sind, wobei eine gegenseitige Positionierung der beiden Gehäuseteile (5; 6) insbesondere durch eine an die erste Zone (Z1) angrenzende Wand der Nut (30) und eine an die erste Zone (Z1) angrenzende Wand des Wulstes (50) bestimmt ist.

4. Stellantrieb nach einem vorangehenden Anspruch, **dadurch gekennzeichnet, dass** minimale Abstand (a) zwischen den beiden Gehäuseteilen (5; 6) in der dritten Zone Z3 zwischen 0,1 mm und 0,2 mm beträgt.

5. Stellantrieb nach einem vorangehenden Anspruch, **dadurch gekennzeichnet, dass** die beiden Gehäuseteile (5; 6) durch Schrauben (7; 8; 9) miteinander verbunden sind.

6. Stellantrieb nach einem vorangehenden Anspruch, **dadurch gekennzeichnet, dass** die beiden Gehäuseteile (5; 6) aus Leichtmetallguss verwirklicht ist.

## Claims

1. Actuating drive (1) having a housing (4) which has a first housing part (5) and a second housing part (6), the two housing parts (5; 6) in each case having a margin (20; 40), in each case with an end face (21; 41), and the two end faces (21; 41) lying opposite one another when the two housing parts (5; 6) are joined together, the first housing part (5) and the second housing part (6) being capable of being joined together releasably and directly, differently acting zones being formed between the two end faces (21; 41) when the two housing parts (5; 6) are joined together, a first zone (Z1), in which the two housing parts (5; 6) touch one another, being formed outwardly on the housing (4), and a second zone (Z2), which has a duct (55), being formed inwardly next to the first zone (Z1), **characterized in that** the duct (55) of the second zone (Z2) in the housing (4) is closed off with respect to a housing inner space (33) by means of a third zone (Z3) in which the two housing parts (5; 6) do not touch one another, the clearance (a) between the two housing parts (5; 6) in the third zone (Z3) being dimensioned in such a way that any water present in the second zone (Z2) cannot flow out through the third zone into the housing inner space (33) on account of surface tensions.

2. Actuating drive according to Claim 1, **characterized in that** the shapes of the two end faces (21; 41) are coordinated with one another such that, in the transitional region between the first zone (Z1) and the second zone (Z2), a mutual abutment is formed, by means of which a mutual displacement of the two housing parts (5; 6) along the margin (20; 40) can be prevented.

3. Actuating drive according to a preceding claim, **characterized in that** a groove (30) is formed in the end face (21) of the first housing part (5), in the region of the second zone (Z2), and a bead (50) is formed, as a counterpiece to the groove (30), in the end face (41) of the second housing part (6), a mutual positioning of the two housing parts (5; 6) being determined, in particular, by a wall, adjacent to the first zone (Z1), of the groove (30) and by a wall, adjacent to the first zone (Z1), of the bead (50).

4. Actuating drive according to a preceding claim, **characterized in that** the minimum clearance (a) between the two housing parts (5; 6) in the third zone (Z3) is between 0.1 mm and 0.2 mm.

5. Actuating drive according to a preceding claim, **characterized in that** the two housing parts (5; 6) are connected to one another by means of screws (7; 8; 9).

6. Actuating drive according to a preceding claim, **characterized in that** the two housing parts (5; 6) are manufactured from cast light metal.

## Revendications

1. Servomoteur (1) comprenant un boîtier (4), qui présente une première partie de boîtier (5) et une seconde partie de boîtier (6), les deux parties de boîtier (5 ; 6) présentant chacune un bord (20 ; 40) avec respectivement une face frontale (21 ; 41) et les deux faces frontales (21 ; 41) se faisant face lors de l'assemblage des deux parties de boîtier (5 ; 6),
la première partie de boîtier (5) et la seconde partie de boîtier (6) pouvant être assemblées de façon amovible et directe,
des zones agissant différemment se formant lors de l'assemblage des deux parties de boîtier (5 ; 6) entre les deux faces frontales (21 ; 41),
une première zone (Z1), dans laquelle les deux parties de boîtier (5 ; 6) se touchent, se formant sur le boîtier (4) horizontalement vers l'extérieur, et
une seconde zone (Z2) présentant un canal (55) se formant vers l'intérieur à côté de la première zone (Z1), et **caractérisé en ce que**
le canal (55) de la seconde zone (Z2) est terminé dans le boîtier (4) en direction d'un espace intérieur de boîtier (33) par une troisième zone (Z3), dans laquelle les deux parties de boîtier (5 ; 6) ne se touchent pas, la distance (a) entre les deux parties de boîtier (5 ; 6) dans la troisième zone (Z3) étant dimensionnée de telle sorte que de l'eau éventuellement présente dans la seconde zone (Z2) ne peut pas s'écouler en raison de tensions de surface au-delà de la troisième zone dans l'espace intérieur de boîtier (33).

2. Servomoteur selon la revendication 1, **caractérisé en ce que** les formes des deux faces frontales (21 ; 41) sont coordonnées de telle sorte qu'une butée réciproque est formée dans la zone de transition entre la première zone (Z1) et la seconde zone (Z2), par laquelle un déplacement réciproque des deux parties de boîtier (5 ; 6) le long du bord (20 ; 40) peut être empêché.

3. Servomoteur selon une revendication précédente, **caractérisé en ce qu'**une rainure (30) est formée dans la face frontale (21) de la première partie de boîtier (5) dans le secteur de la seconde zone (Z2) et un renflement (50) est formé dans la face frontale (41) de la seconde partie de boîtier (6) comme pendant à la rainure (30), un positionnement réciproque des deux parties de boîtier (5 ; 6) étant déterminé en particulier par une paroi, contiguë à la première zone (Z1), de la rainure (30) et une paroi, contiguë à la première zone (Z1), du renflement (50).

4. Servomoteur selon une revendication précédente, **caractérisé en ce que** la distance minimale (a) entre les deux parties de boîtier (5 ; 6) dans la troisième zone (Z3) se situe entre 0,1 mm et 0,2 mm.

5. Servomoteur selon une revendication précédente, **caractérisé en ce que** les deux parties de boîtier (5 ; 6) sont reliées entre elles par des vis (7 ; 8 ; 9).

6. Servomoteur selon une revendication précédente, **caractérisé en ce que** les deux parties de boîtier (5 ; 6) sont réalisées en fonte de métal léger.
